(19) Europäisches Patentamt
European Patent Office
Office européen des brevets

(11) **EP 2 403 145 A1**

(12) **EUROPEAN PATENT APPLICATION**

(43) Date of publication:
**04.01.2012 Bulletin 2012/01**

(51) Int Cl.:
*H03M 1/12* (2006.01)    *H04B 1/28* (2006.01)
*H04B 1/40* (2006.01)    *H04B 1/00* (2006.01)

(21) Application number: **10168109.6**

(22) Date of filing: **01.07.2010**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**
Designated Extension States:
**BA ME RS**

(71) Applicant: **Fraunhofer-Gesellschaft zur Förderung
der
angewandten Forschung e.V.
80686 München (DE)**

(72) Inventors:
• **Mayer, Frank, Dipl.-Inf.
91083 Baiersdorf (DE)**
• **Leyh, Martin, Dipl.-Ing.
91058 Erlangen (DE)**
• **Schlicht, Michael, Dipl.-Ing.
90602 Pyrbaum (DE)**

(74) Representative: **Zimmermann, Tankred Klaus et al
Schoppe, Zimmermann, Stöckeler
Zinkler & Partner
P.O. Box 246
82043 Pullach (DE)**

(54) **A receiver and a method for processing a signal**

(57)    A receiver comprises a splitter, an analog-to-digital converter block and a combiner. The splitter is configured to receive a receiver input signal, comprising a first bandwidth and a first frequency range. The splitter is further configured to provide a first splitter output signal and a second splitter output signal, such that the first splitter output signal comprises a second bandwidth and a second frequency range, the second bandwidth being smaller than the first bandwidth, and such that the second splitter output signal comprises a third bandwidth, the third bandwidth being smaller than the first bandwidth. The analog-to-digital converter block is configured to provide a first digital signal based on the first splitter output signal and to provide a second digital signal based on the second splitter output signal. The combiner is configured to provide a combined digital signal, comprising the first bandwidth, based on the first digital signal and the second digital signal.

EP 2 403 145 A1

## Description

Embodiments of the present invention relate to a receiver, especially for receiving wideband frequency range signals. Other embodiments of the present invention relate to a method for processing a signal, in particular, a wideband frequency range signal.

In a typical digital receiver, the bandwidth of the analog tuner and the sampling rate of the analog-to-digital converter (ADC) set an upper limit to the bandwidth of the signal that such a receiver can process. If information is transmitted using a single radio frequency (RF) channel, tuner and ADC limit the maximum bandwidth of that RF channel. Thus, assuming a given roll-off factor, modulation scheme and signal mapping, the maximum occupied bandwidth and thus the number of bits that can be transmitted per time is also bound by the technical constraints of the tuner and ADC.

For example, chips available to on the market for DVB-S (Digital Video Broadcast over Satellite) and DVB-S2 (Digital Video Broadcasting over Satellite - Second Generation) reception limit the analog bandwidth of the tuner to a maximum of approx. 100 MHz. Programming the Phase-Locked-Loop (PLL) and mixer integrated in the tuner, this maximum 100 MHz "window" can be placed at discrete positions within the typ. 950 MHz to 2150 MHz intermediate frequency range of the down-converted C-, Ku- or Ka-Band satellite transponder signal. Thus with a single tuner, only approx. 100 MHz out of the total bandwidth of e.g. 1200 MHz can be decoded at any given time. Assuming a typical roll-off of 0.35, a 100 MHz signal bandwidth corresponds to a maximum of 75 million symbols (encoding e.g. 2, 3, 4 or 5 raw channel bits) per second.

US6031878 discloses the basic architecture used for integrated satellite tuner chips today. This architecture (Figure 2 of US6031878) is essentially composed of a gain controlled first Low Noise Amplifier (LNA), followed by a mixer to baseband (including IQ separation) and a configurable baseband low-pass filter (LPF). The down-converted IQ signal is further amplified in a second LNA and then digitalized using a 2-channel ADC, and then further decoded in the digital domain.

US6031878 also discloses details on prior art (Figure 1 of US6031878). This prior art architecture is composed of a first LNA, followed by a mixer to an intermediate frequency and then followed by a fixed-center frequency Surface Acoustic Wave (SAW) filter. A second mixer down-converts (including IQ separation) the signal to baseband, followed by a low-pass filter (LPF) and a 2-channel ADC, for further decoding in the digital domain.

In US6031878, the maximum filter bandwidth of the configurable LPF, together with the frequency response of the analog processing (including LNA and mixer) and the sampling rate of the ADC, limits the maximum signal bandwidth that can be processed. The same is true for the prior art shown in Figure 1 of US6031878: Here the pass-bandwidth of the SAW and the low-pass filter, together with the frequency response of the analog processing (including LNA and mixer) and the sampling rate of the ADC limits the maximum signal bandwidth that can be processed.

US7095454 discloses extensions to the basic architecture shown in US6031878, with the intention to improve performance related to "(...) unwanted signals, including image, harmonics, spurious, and other undesired signals " (see paragraph 2 of US7095454). This invention includes a number of sub-band filters in the RF domain, between first LNA and mixer, with the purpose of being able to select one depending on the RF frequency band of interest.

US2009/0258629A1 discloses another variant of a tuner architecture, with a first mixer to high intermediate frequency (IF) and filters on this high IF, followed by a second mixer to low IF (or baseband), plus additional filtering. The application relates to an "agile RF tuner that converts a relatively wide portion of the incoming RF (...)" (see paragraph 1 of US2009/0258629A1), with the focus to allow a frequency range on the RF side. The maximum signal bandwidth remains limited, similar to·US6031878 and US7095454.

US7167694 discloses another variant of the tuner architecture and integrates more than two tuner branches. The novelty in the tuner architecture relates to a first coarse tuning to the desired RF frequency and a second fine tuning in the digital domain. The integration of (at least) two tuner branches is done for the purpose of making (at least) two independent configurable sets of transponder channels, each including "(...) a plurality of program channels" (see paragraph 4 and claim 1 of US7167694) available for further processing.

US7304689 also discloses a receiver with multiple tuner branches. This invention follows the need of utilizing "(...) multiple TV tuners, such as for providing picture-in-picture functionality or for recording multiple programs (...)" (see paragraph 3 of US7304689) and discloses efficient means of cascading the tuner circuits.

US2006/0128328 follows the need of having to utilize more tuners to simultaneously access multiple programs. It differs from US7304689 in proposing a multi-drop connectivity to the multiple tuners instead of the cascading.

US6519011 and US6363262 disclose similar use cases for receiving a plurality of programs using more than one tuner.

US5590156 discloses "a technique for extending the instantaneous dynamic range available in a wideband digital base station (...)", (see abstract of US5590156) using multiple tuner branches. The main focus lies on the parallel operation of the tuners within different frequency bands, each providing multiple channel signals, in combination with an assignment of the channel signals to the individual branches, e.g. depending on received signal strength (RSSI).

As mentioned before, in the art, the maximum bandwidth of a single channel is limited by technology constraints of the tuner implementation (e.g. filter bandwidth, frequency response of the low noise amplifier and mixer circuits employed).

As it can be seen from the above mentioned documents, multi-part tuner architectures are known, which either focus on extending the number of available parallel transponder channels and/or programs, or on improving performance by assigning each tuner branch to programs (or sets of programs) with similar signal properties. In both cases, a bandwidth limit for each channel is set by the respective tuner branch.

However, because of the rising demand in regard to data rate, there may be use cases in the art where channel bandwidths beyond the limits of today's tuner technology are favorable.

Therefore it is an object of the present invention to create a concept, which allows for a higher bandwidth limit of a receiver.

This object is solved by a receiver according to claim 1, a method according to claim 15 and a computer program according to claim 16.

Embodiments of the present invention provide a receiver comprising a splitter, an analog-to-digital converter block and a combiner. The splitter is configured to receive a receiver input signal, comprising a first bandwidth and a first frequency range. This splitter is further configured to provide, based on the receiver input signal, a first splitter output signal, such that the first splitter output signal comprises a second bandwidth and a second frequency range, the second bandwidth being smaller than the first bandwidth. The splitter is further configured to provide, based on the receiver input signal, a second splitter output signal, such that the second splitter output signal comprises a third bandwidth and a third frequency range, the third bandwidth being smaller than the first bandwidth.

The analog-to-digital converter block is configured to provide a first digital signal based on the first splitter output signal and to provide a second digital signal based on the second splitter output signal.

An analog-to-digital converter is in the following also called AD converter or ADC.

The combiner is configured to provide a combined digital signal based on the first digital signal and the second digital signal, such that the combined digital signal has the first bandwidth.

It is an idea of embodiments of the present invention that a bandwidth limit of a signal that a receiver can process can be higher, if an incoming analog input signal with a first bandwidth is split into at least two analog signals, each having a smaller bandwidth than the original receiver input signal. These two or more signals can then be converted to digital signals and be combined to a digital version of the original input signal having the same bandwidth as the original input signal.

It is an advantage of embodiments of the present invention that a bandwidth of a signal that a receiver can process is no longer limited by an analog part (e.g. by an ADC sampling rate and/or tuner limitations) of the receiver as is the case with the concepts described in the introductory portion of this application.

Embodiments of the present invention allow a receiver, which can process a receiver input signal having a higher bandwidth than the bandwidth limit of its analog-to-digital converter, by providing the first splitter output signal comprising the second bandwidth (which may be smaller than (or within) the bandwidth limit of the AD converter) and by providing the second splitter output signal comprising the third bandwidth (which may also be smaller than (or within) the bandwidth limit of the AD converter). The AD converter may therefore provide the first digital signal based on the first splitter output signal without any (or only insignificantly low) information loss due to the bandwidth limit of the AD converter, and may also provide the second digital signal based on the second splitter output signal without any (or only insignificantly low) information loss due to the bandwidth limit of the AD converter. Therefore, the complete first bandwidth of the receiver input signal is covered by the receiver, even if the first bandwidth is bigger than (or contains frequencies outside) the bandwidth limit of the AD converter.

In other words, the bandwidth limit of the AD converter may be smaller than the first bandwidth of the receiver input signal and of the combined digital signal. The combined digital signal may for example be a digital version of the receiver input signal, without any information loss.

Another advantage of embodiments of the present invention is that an upper limit of a bandwidth of the signal that a receiver according to an embodiment of the present invention can process is not dependent on a bandwidth limit of the used AD converter, but scales with a number of splitter output signals, which are then converted into digital signals. A bandwidth of each of these splitter output signals may be smaller than a bandwidth limit of the used AD converter, such that every splitter output signal can be converted into the digital domain without any (or only insignificantly low) information loss.

According to some embodiments of the present invention, the receiver input signal may correspond to a channel of interest, having the first bandwidth and lying in the first frequency range. The first splitter output signal may correspond to a first fraction of the channel of interest and the second splitter output signal may correspond to a second fraction of the channel of interest.

In this application a fraction of the channel of interest is defined as a part of the channel of interest, which is not meaningfully decodable without the remaining fractions of the channel of interest, as for example a sub-channel would be. Therefore, the fractions of the channel of interest have to be combined (in the digital domain) before decoding the channel of interest.

According to further embodiments of the present invention, the second frequency range of the first splitter output signal may correspond to a first portion (e.g. to the abovementioned first fraction) of the first frequency range of the receiver input signal and the third frequency range of the second splitter output signal may correspond to a second portion (e.g. to the abovementioned second fraction) of the first frequency range of the receiver input signal.

In other words, information carried in the second frequency range of the first splitter output signal may be the same information as carried in the first portion of the receiver input signal. A bandwidth of the first portion may therefore be the same as the second bandwidth. Analog to this may information carried in the third frequency range of the second splitter output signal be the same information as carried in the second portion of the receiver input signal. A bandwidth of the second portion may therefore be the same as the third bandwidth.

Therefore, the second frequency range may contain the same frequencies like the first portion of the first frequency range or a frequency shifted version thereof and the third frequency range may contain the same frequencies like the second portion of the first frequency range, or a frequency shifted version thereof.

According to further embodiments of the present invention, the first portion of the first frequency range may be adjacent to the second portion of the first frequency range. Therefore, a frequency contained in the first frequency range corresponds to either a frequency in the second frequency range or a frequency in the third frequency range. By placing the portions adjacent to each other a number of splitter output signals and therefore a complexity of the receiver can be reduced.

According to further embodiments of the present invention, the first portion and the second portion may overlap in a common overlap area, which is smaller than the first bandwidth and the second bandwidth. This means, that chosen frequencies of the first frequency range correspond to both a frequency in the second frequency range and a frequency in the third frequency range.

The main benefit of embodiments of the present invention is to overcome the technological and components limitations that restrict the bandwidth of a tuner and ADC. These technological limitations are overcome by architectural means, for example, the solution virtually scales unlimited with the number of tuner and ADC branches employed.

Integrated tuner solutions for DVB-S and DVB-S2 available on the market today are tailored for the commercial and bandwidth requirements of their mainstream market

("Satellite TV") and are optimized for cost ("bill-of-material"). There is no integrated solution known to exist on the market that supports RF bandwidths in excess of 100 MHz. Although such a tuner could be built based on discrete components, such a discrete solution would be disadvantageous regarding bill-of-material, board space required, power consumption and manufacturing yield.

ADCs supporting the bandwidths and sampling rates above 100 MHz (up to the GHz range) are available today.

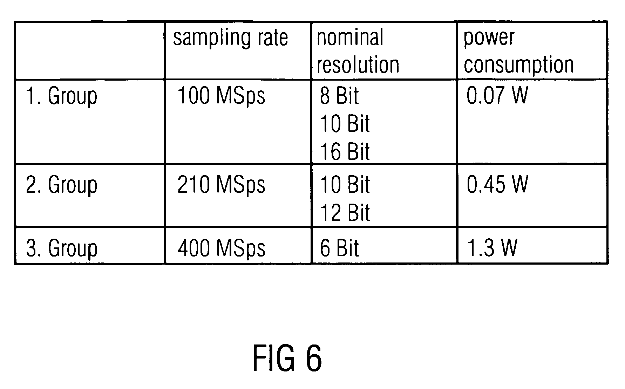

Fig. 6 shows a table which shows a first group of available ADCs having a sampling rate of about 100 Megasamples per second (MSPS), a second group of available ADCs having a sampling rate of about 210 MSPS and a third group of available ADCs having a sampling rate of about 400 MSPS, as can be seen from the table in Fig. 6 there is a non-linear growth in power consumption with sampling rate, while the precision (nominal and effective number of bits) declines. Also the price of the ADCs (not show in the table in Fig. 6) grows non-linear with the sampling rate.

Furthermore, ADCs in the range up to about 100 MSps can be integrated into standard (digital) CMOS chips, which allow for a very space and cost efficient implementation of a larger number of ADC branches.

All in all, while it is possible to build a single branch wideband tuner / ADC solutions with specialized technologies available today, the proposed n-branch tuner / ADC solution can be built based on standard technologies or components available and yields better bill-of-material and power dissipation.

Regarding the digital processing, another advantage of embodiments of the present invention, is that n (or 2*n in the case of an IQ signal) digital streams are output in parallel. Thus the per-stream rate is only 1/n (or 1/(2*n) in case of IQ) of the rate of an equivalent full-bandwidth stream. This significantly reduces the input requirements (sampling rate, jitter, buffer) for the digital processing (e.g. by a digital conditioner) that follows.

There are use cases were channel bandwidths beyond the limits of today's tuner technology are favorable. Embodiments of the present invention describe a front-end architecture that uses a parallel arrangement of at least two tuner and ADC branches, tuned to cover adjacent or overlapping portions of a given wideband signal. This architecture is complemented by means for reconstruction of the full wideband signal in the digital domain. Embodiments of the present invention overcome the bandwidth restriction of each individual branch; the overall supported/covered signal bandwidth effectively scales linear with the number of branches.

As mentioned before, multi-branch tuner architectures are known, which either focus on extending the number of parallel available transponder channels and/or programs, or on improving performance. In both cases, the bandwidth of each channel (carrying a program package) does not exceed the band-pass of the respective tuner branch. Therefore the documents mentioned in the introductory portion of this application do not address the reverse problem of using multiple tuners to overcome the bandwidth limit for an individual channel, allowing the per-channel bandwidth to exceed the bandwidth limits of the individual tuner, such as is the case with embodiments of the present invention.

As stated before, a single branch wideband tuner ADC combination is technically feasible, but such a solution comes with technical and commercial drawbacks as has been shown together with the table of Fig. 6.

Embodiments of the present invention may provide an integrated implementation of n tuner and ADC branches, with digital streams at the output of the ADC.

The primary use case of embodiments of the present inventions is related to receiver technology for example terrestrial and satellite broadcasting, where wideband channels are being broadcast. From a system perspective, use of wideband channels (wider than used today) may be beneficial for the spectral efficiency of the system and thus result in a better per-bit cost.

A receiver according to an embodiment of the present invention may also be called a frontend or a wideband frontend or a wideband frontend for a receiver, especially for a digital receiver, for example a DVB-S receiver.

A second use case also relates to receiver technology, for example for terrestrial and satellite broadcasting where several narrow band channels are placed arbitrarily within a wideband frequency band. Embodiments of the present invention can cover the full wideband frequency range, reconstruct all narrow band channels (even if they fall into the frequency range covered by adjacent or overlapping branches) and a parallel or selective decoding of the narrow band channel(s).

Another use case is in the domain of wideband monitoring receivers. Using this invention, the RF bandwidth covered by such a receiver could be increased by a factor of n (n=number of branches). This is especially useful if the signal of interest is of a large and unknown bandwidth, e.g. if frequency spread techniques are employed. This use case also includes UWB (Ultra Wide Band) communication equipment.

According to further embodiments of the present invention, the receiver input signal may not be an RF signal, but a signal coming through a wired link, e.g. from a signal generator or any other communication equipment, which communicates through a wired link (e.g. using a cable or fiber optics.).

Brief Description of the Drawings

Embodiments of the present invention will be explained in the following referring to the accompanying figures, wherein:

Fig. 1a    shows a block diagram of a receiver according to an embodiment of the present invention;

Fig. 1b    shows diagrams of signals as they may occur in the receiver from Fig. 1a;

Fig. 2a    shows a block diagram of a receiver according to a further embodiment of the present invention;

Fig. 2b    show different digital conditioners, which may be employed in the receiver from Fig. 2a;

Fig. 3    shows diagrams of signals as they may occur in the receiver from Fig. 2a;

Fig. 4    show different digital conditioners, which may be employed in the receiver from Fig. 2a;

Fig. 5    shows a flow diagram of a method according to an embodiment of the present invention; and

Fig. 6    shows a table of commercially available analog-to-digital converters.

Description of Embodiments of the Invention

Before embodiments of the present invention will be explained in greater detail in the following on the basis of the figures, it is to be pointed out that the same or functionally equal elements are provided with the same reference numbers, and that a repeated description of these elements shall be omitted. Hence, the description of elements provided with the same reference numerals is mutually interchangeable and/or applicable in the various embodiments.

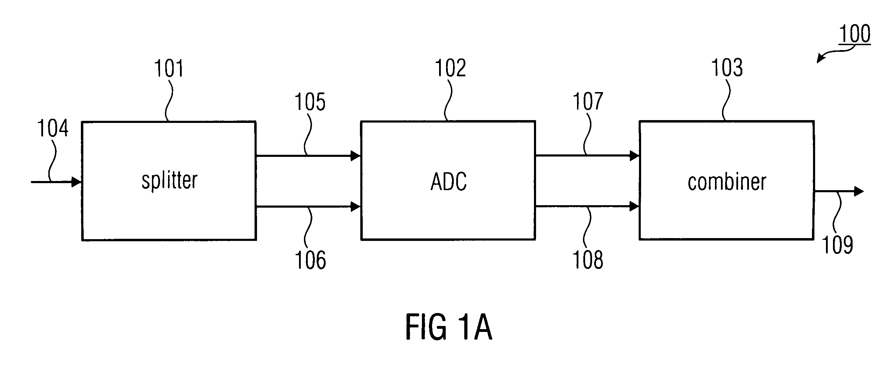

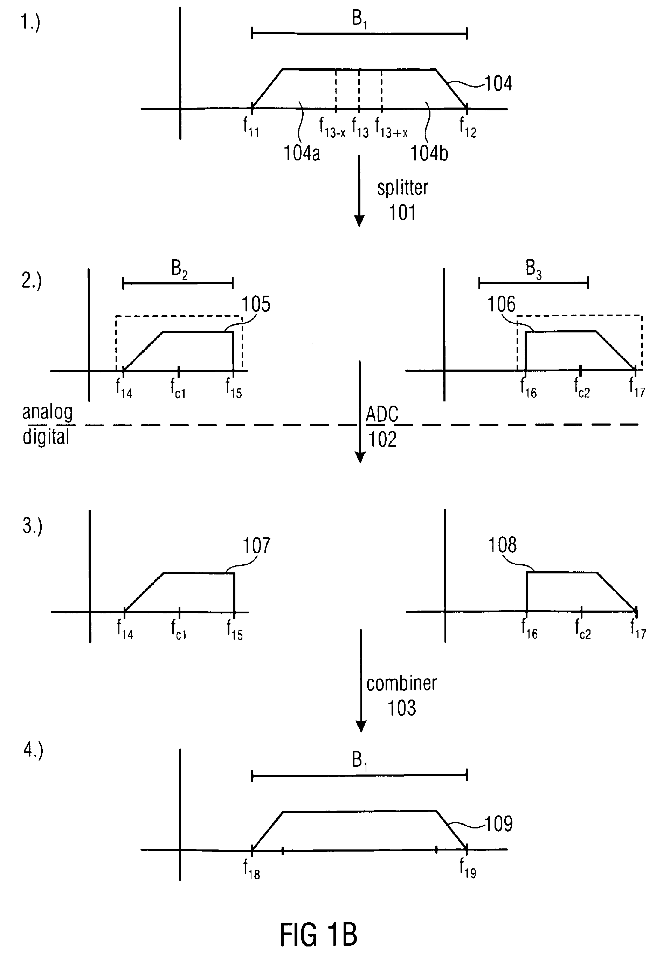

Fig. 1a shows a block diagram of a receiver 100 according to an embodiment of the present invention. Fig. 1 b shows, for a better understanding, diagrams of possible signals how they may occur in the receiver 100.

The receiver 100 comprises a splitter 101, an analog-to-digital converter block 102 and a combiner 103. The splitter 101 is configured to receive a receiver input signal 104, which for example may be a wideband signal. This receiver input signal 104 comprises a first bandwidth $B_1$ and a first frequency range. The splitter 101 is further configured to provide, based on the receiver input signal 104, a first splitter output signal 105, such that the first splitter output signal comprises a second bandwidth $B_2$ and a second frequency range. The second bandwidth $B_2$ is smaller than the first bandwidth $B_1$ of the receiver input signal 104. The splitter 101 is further configured to provide, based on the receiver input signal 104, a second splitter output signal 106 comprising a third bandwidth $B_3$ and a third frequency range. The third bandwidth $B_3$ is also smaller than the first bandwidth $B_1$. The analog-to-digital converter block 102 is configured to provide a first digital signal 107 based on the first splitter output signal 105 and to provide a second digital signal 108 based on the second splitter output signal 106. The combiner 103 is configured to provide a combined digital signal 109 based on the first digital signal 107 and the second digital signal 108. The combined digital signal 109 comprises the first bandwidth (such as the receiver input signal 104).

Fig. 1b shows in an example how the receiver 100 shown in Fig. 1a may operate. In the first diagram a first receiver input signal 104 is shown, how it may be applied to the splitter 101. This receiver input signal 104 may for example be a wideband signal representing a channel of interest. The receiver input signal 104 comprises the first bandwidth $B_1$ and the first frequency range, which in the example in Fig. 1b ranges from a smallest frequency $f_{11}$ of the receiver input signal 104 to a highest frequency $f_{12}$ of the receiver input signal 104. The bandwidth $B_1$ of the receiver input signal 104 is the difference between the highest frequency $f_{12}$ and the lowest frequency $f_{11}$ of the receiver input signal 104. A center frequency of the receiver input signal 104, which is in the middle between the lowest frequency $f_{11}$ and the highest frequency $f_{12}$ of the receiver input signal 104 is the frequency $f_{13}$. The splitter 101 provides the first splitter output signal 105 and the second splitter output signal 106 based on the receiver input signal 104, which is shown in the second diagram of Fig. 1b.

As mentioned before, the first splitter output signal 105 comprises the second bandwidth $B_2$, which is smaller than the first bandwidth $B_1$ of the receiver input signal 104 and the second splitter of the signal 106 comprises the third bandwidth $B_3$ which is smaller than the first bandwidth $B_1$ of the receiver input signal 104. In the example shown in Fig. 1b, the second frequency range (of the first splitter output signal 105) ranges from a lowest frequency $f_{14}$ to a highest frequency $f_{15}$ of the first splitter output signal 105. The third frequency range (of the second splitter output signal 106) ranges from a lowest frequency $f_{16}$ to a highest frequency $f_{17}$ of the second splitter output signal 106.

According to some embodiments of the present invention, the second frequency range (of the first splitter output signal 105) may correspond to a first portion 104a of the first frequency range of the receiver input signal 104 and the third frequency range (of the second splitter output signal 106) may correspond to a second portion 104b of the first frequency range of the receiver input signal 104. In the example shown in Fig. 1b, the first portion 104a of the first frequency range ranges from the lowest frequency $f_{11}$ to the center frequency $f_{13}$ of the first frequency range and the second portion 104b of the first frequency range ranges from the center frequency $f_{13}$ to the highest frequency $f_{12}$ of the first frequency range. Therefore, the first portion 104a and the second portion 104b are adjacent to each other. Hence, the lowest frequency $f_{14}$ of the second frequency range corresponds to the lowest frequency $f_{11}$ of the first frequency range and the highest frequency $f_{15}$ of the second frequency range corresponds to the center frequency $f_{13}$ of the first frequency range. The lowest frequency $f_{16}$ of the third frequency range corresponds to the center frequency $f_{13}$ of the first frequency range and the highest frequency $f_{17}$ of the third frequency range corresponds to the highest frequency $f_{12}$ of the first frequency range. A sum of the second bandwidth $B_2$ and the third bandwidth $B_3$ therefore equals the first bandwidth $B_1$.

In addition to the first portion 104a and the second portion 104b being adjacent to each other, as shown in the example, the first portion 104a and the second 104b may also overlap in a common overlap area. This common overlap area may for example range from a frequency $f_{13-x}$ to a frequency $f_{13+x}$ of the first frequency range. The highest frequency $f_{15}$ of the second frequency range would then correspond to the frequency $f_{l3+x}$ of the first frequency range and the lowest frequency $f_{16}$ of the third frequency range would correspond to the frequency $f_{13-x}$ of the first frequency range. The common overlap area may be smaller than the second bandwidth and the third bandwidth.

For a person skilled in the art, it becomes clear that the shown principle of splitting the receiver input signal 104 into two splitter output signals may be extended to a freely chosen number of splitter output signals, wherein each splitter output signal has its own bandwidth and frequency range. A frequency range of each splitter output signal may correspond to a portion of the first frequency range of the receiver input signal 104. A number of splitter output signals may be determined based on the first bandwidth $B_1$ of the receiver input signal 104 and on a bandwidth limit of the analog-to-digital converter block 102.

As an example, a bandwidth limit of the analog-to-digital converter block 102 may be slightly larger than the second bandwidth $B_2$ and the third bandwidth $B_3$, but smaller than the first bandwidth $B_1$. As an example, a possible bandwidth limit of the analog-to-digital converter block 102 is shown in the second diagram by the use of dashed lines. Embodiments of the present invention therefore create a receiver, which is able to process a receiver input signal, which has a higher bandwidth than the bandwidth limit of its analog-to-digital converter.

According to further embodiments of the present invention, the splitter 101 may be configured to provide the first splitter output signal 105 such that a center frequency of the first portion 104a, which corresponds to the second frequency range, is different to a center frequency $f_{c1}$ of the second frequency range, and to provide the second splitter output signal 106 such that a center frequency of the second portion 104b corresponding to the third frequency range is different to a center frequency $f_{c2}$ of the third frequency range. In other words, the splitter 101 may be configured to perform a frequency shift, such that the first splitter output signal 105 is centered around the center frequency $f_{c1}$ and such that the second splitter output signal 106 is centered around the center frequency $f_{c2}$. The center frequency $f_{c1}$ and $f_{c2}$ may for example be equal and may be low or zero (e.g. in the case of separated IQ signals) intermediate frequencies. By centering the first splitter output signal 105 and the second splitter output signal 106, at low or zero IF (intermediate frequencies), the analog-to-digital converter block 102 may be configured similarly to provide the first digital signal 107 based on the first splitter output signal 105, and to provide the second digital signal 108 based on the second splitter output signal 106.

As mentioned before, the analog-to-digital converter block 102 provides the first digital signal 107 based on the first splitter output signal 105, and the second digital signal 108 based on the second splitter output signal 106. According to further embodiments of the present invention, the analog-to-digital converter block 102 may provide the first digital signal 107 and the second digital signal 108 simultaneously, for example by comprising a first ADC branch (or a first converting branch) for the first digital signal 107 and by comprising a second ADC branch (or a second converting branch) for the second digital signal 108. According to further embodiments, the analog-to-digital converter block 102 may provide the first digital signal 107 and the second digital signal 107 sequentially, for example by firstly providing the first digital signal 107 and by using a sample and hold stage for providing the second digital signal 108 after the first digital signal 107.

The combiner 103 provides the combined digital signal 109 based on the first digital signal 107 and the second digital signal 108. As mentioned before, the combiner 103 is configured to provide the combined digital signal 109, such that it comprises the first bandwidth of the receiver input signal 104. A frequency range of the combined digital signal 109 may be different than the first frequency range, which means that a lowest frequency $f_{18}$ of the frequency range of the combined digital signal 109 may differ from the lowest frequency $f_{11}$ of the first frequency range and a highest frequency range $f_{19}$ of the frequency range of the combined digital signal 109 may differ from the highest frequency $f_{12}$ of the first frequency range of the receiver input signal 104. In other words, the combined digital signal 109 may be a digital and frequency shifted version of the receiver input signal 104.

As mentioned before, the first digital signal 107 and the second digital signal 108 may be centered around a common low or zero intermediate frequency. Therefore, the first digital signal 107 and/or the second digital signal 108 may be frequency shifted before being fed into the combiner 103 to provide the combined digital signal 109.

Furthermore, the first digital signal 107 and the second digital signal 108 may be amplitude and/or phase and/or time aligned and band-pass filtered before being fed into the combiner 103.

The combined digital signal 109 represents the channel of interest being contained in the receiver input signal 104 in a digital domain. The combined digital signal 109 may be decoded in a further stage of the receiver 100.

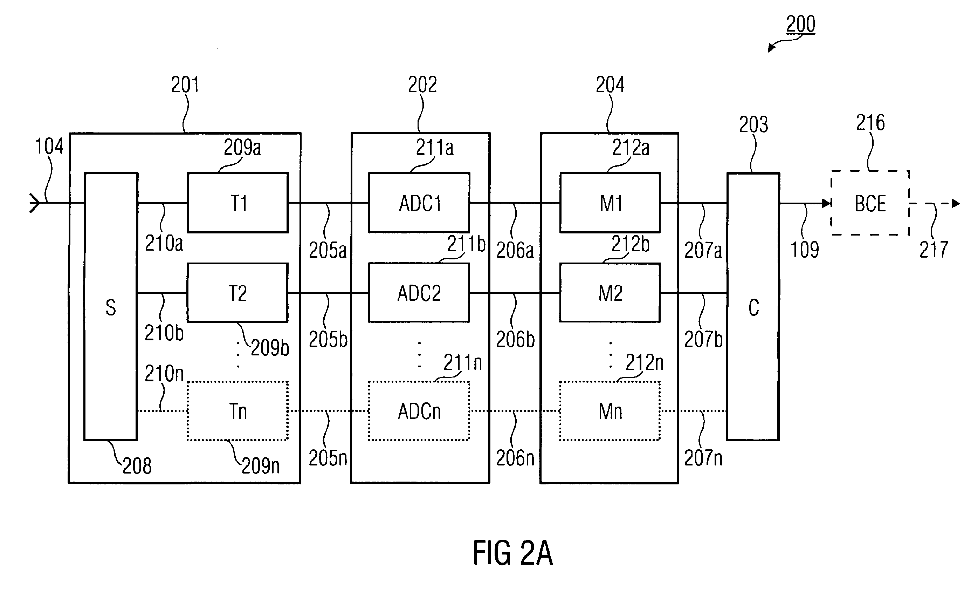

Fig. 2a shows a block diagram of a receiver 200 according to a further embodiment of the present invention. The receiver 200 comprises a splitter 201, which may for example be the splitter 101 shown in Fig. 1a. The receiver 200 further comprises an analog-to-digital converter block 202, which for example may be the analog-to-digital converter block 102 from Fig. 1a. The receiver 200 further comprises a combiner 203, which may for example be the combiner 103 from Fig. 1a.

According to further embodiments, the receiver 200 may comprise a digital conditioner 204. The digital conditioner 204 may be arranged between the analog-to-digital converter block 202 and the combiner 203. The splitter 201 is configured to provide, based on a receiver input signal 104, which for example may correspond to a channel of interest, a plurality of splitter output signals 205a to 205n, each splitter output signal 205a to 205n having a bandwidth and a frequency range. A frequency range of each splitter output signal 205a to 205n may each correspond to a portion of the receiver input signal 104. Each splitter output signal 205a to 205n may therefore represent a fraction of the channel of interest. The splitter 201 may be configured to provide the plurality of splitter output signals 205a to 205n such that every portion of the first frequency range corresponds to at least one frequency range of a splitter output signal of the plurality of splitter output signals 205a to 205n. In other words, frequency ranges of the plurality of splitter output signals 205a to 205n may together represent the complete first frequency range of the receiver input signal 104 and therefore the complete channel of interest.

The analog-to-digital converter block 202 is configured to provide a plurality of digital signals 206a to 206n based on the plurality of splitter output signals 205a to 205n. In other words, the plurality of digital signals 206a to 206n may be a digital representation of the plurality of (analog) splitter output signals 205a to 205n. Therefore, each digital signal 206a to 206n may represent one fraction of the channel of interest in the digital domain. As it has been mentioned previously, the receiver 200 may comprise the digital conditioner 204 in between the analog-to-digital converter block 202 and the combiner 203. The digital conditioner 204 is configured to provide a plurality of conditioned digital signals 207a to 207n based on the digital signals 206a to 206n. The combiner 203 is therefore configured to provide the combined digital signal 109 based on the plurality of conditioned digital signals 207a to 207n.

The digital conditioner 204 may be configured to perform a digital processing on the plurality of digital signals 206a to 206n. The digital conditioner 204 may for example be figured to perform a band-pass filtering of the plurality of digital signals 206a to 206n, a frequency shifting of the plurality of digital signals 206a to 206n and/or an amplitude and/or phase and/or time alignment of the digital signals 206a to 206n.

As it can be seen from Fig. 2a, the splitter 201 may comprise a splitting stage (S) 208 and a plurality of tuner branches (Tl-Tn) 209a to 209n. The splitting stage 208 may be configured to provide a plurality of splitting stage output signals 210a to 210n. These splitting stage output signals 210a to 210n may for example be identical and amplified versions of the receiver input signal 104. Each of the splitting stage output signals 210a to 210n may comprise the first bandwidth and the first frequency range of the receiver input signal 104. A first tuner branch 209a may be configured to provide a first splitter output signal 205a based on a first splitting stage output signal 210a and a second tuner branch 209b may be configured to provide a second splitting output signal 205b based on a second splitting stage output signal 210b. In other words, the tuner branches 209a to 209n may be configured to provide a plurality of splitter output signals 205a to 205n based on the plurality of splitting stage output signals 210a to 210n. A passband of the first tuner branch 209a may correspond to the first portion of the first frequency range and a passband of the second tuner branch may correspond to the second portion of the second frequency range. This may also apply for the other tuner branches of the plurality of tuner branches 209a to 209n, such that every tuner branch out of the plurality of tuner branches 209a to 209n comprises a passband which corresponds to the portion of the first frequency range of the receiver input signal 104 to which the frequency range of its splitter output signal 205a to 205n correspond. Furthermore, the first tuner branch 209a may be configured to provide the first splitter output signal 205a such that a center frequency of a frequency range of the first splitter output signal 205a is lower than the center frequency of the first portion (corresponding to the frequency range of the first splitter output signal 205a) of the first frequency range of the receiver input signal 104. The second tuner branch 209b may be configured to provide the second splitter output signal 205b such that a center frequency of a frequency range of the second splitter output signal 205b is lower than the center frequency of the second portion (corresponding to the frequency range of the second splitter output signal 205b) of the first frequency range of the receiver input signal 104. In other words, the tuner branches 209a to 209n may be configured to perform a frequency shift and a filtering of the plurality of splitting stage output signals 210a to 210n. The tuner branches 209a to 209n may for example be configured to frequency shift the splitting stage output signals 210a to 210n to a low or zero - IF. The center frequencies of the splitting stage output signals 205a to 205n may for example be identical. For example, the center frequency of the frequency range of the first splitter output signal 205a may be equal to the center frequency of the frequency range of the second splitter output signal 205b.

As it has been mentioned above, the analog-to-digital converter block 202 may be configured to simultaneously or sequentially provide the plurality of digital signals 206a to 206n. In the example shown in Fig. 2a, the analog-to-digital converter block 202 is configured to simultaneously provide the plurality of digital signals 206a to 206n. The analog-to-digital converter block 202 therefore comprises a plurality of converting branches (ADC1 to ADCn) 211a to 211n. Each converting branch 211a to 211n may be configured to provide one of the digital signals 206a to 206n based on one of the splitter output signals 205a to 205n. For example, the first converting branch 211a may be configured to provide the first digital signal 206a based on the first splitter output signal 205a and a second converting branch 211b may be converted to provide the second digital signal 206b based on the second splitter output signal 205b. A bandwidth limit of the converting branches 211a to 211n may be bigger than a bandwidth of a splitter output signal, on the basis of which the converting state provides its digital signal. However, the bandwidth limit of this converting branch may be smaller than the bandwidth of the receiver input signal 104 and the combined digital signal 109. The plurality of converting branches 211a to 211n may be identical and may furthermore be configured to work in the same frequency range (e.g. if the splitter output signals 205 to 205n have been shifted by its tuner branches 209a to 209n to the same intermediate frequency).

As it can be seen from Fig. 2a, the digital conditioner 204 may comprise a plurality of conditioning stages (M1-Mn) 212a to 212n, each being configured to provide one of the conditioned digital signals 207a to 207n, based on one of the digital signals 206a to 206n. For example a first conditioning stage 212a may be configured to provide a first conditioned digital signal 207a based on the first digital signal 206a and a second conditioning stage 212b may be configured to provide a second conditioned digital signal 207b based on the second digital signal 206b. Each of the conditioning stages 212a to 212n may perform the abovementioned band-pass filtering and/or frequency shifting and/or amplitude and/or phase and/or time alignment.

As can be seen from Fig. 2a, each splitting stage output signal 210a to 210n (which may be an amplified version of the receiver input signal 104) processed in analog may be converted to digital and processed in digital in its own tuner-ADC-conditioner branch. Therefore a bandwidth limit (e.g. set by the analog tuner-ADC branch) only applies to a portion of the first frequency range of the receiver input signal 104 to which the frequency range of the corresponding splitter output signal corresponds. A bandwidth limit of the complete receiver 200 scales linear with a number of tuner-ADC-conditioner branches and is not limited by a bandwidth limit of the analog tuner-ADC branch.

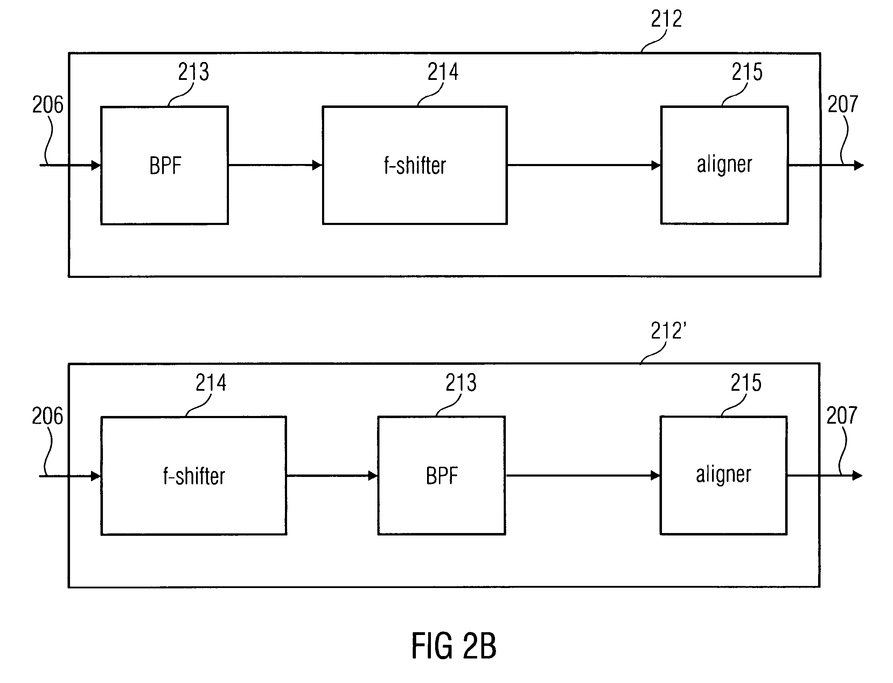

In the following, the receiver 200 will be explained in more detail using Figs. 2b, 3 and 4.

An RF signal (the receiver input signal 104), for example coming from a reception antenna or a cable or another signal provider, which may optionally be down converted by a low noise block converter (LNB) is connected to an input of the splitter 201 and therefore to an input of the splitting stage (S) 208. The n outputs (the plurality of splitting stage output signals 210a to 210n) of this splitting stage 208 are connected to the individual tuner branches (T1 to Tn) 209a to 209n. Each of the tuner branches 209a to 209n conditions and down converts the signal (the splitting stage output signals 210a to 210n). The resulting signal (the splitter output signal 205a to 205n) is then converted from analog to digital in each respective branch using the converting branches (ADC1 to ADCn) 211a to 211n. The resulting digital signals (the digital signals 206a to 206n) are further conditioned and processed in the digital domain (by the conditioning stages 212a to 212n) and then fed into the combiner (C) 203 that appropriately combines the signal components from the n branches (the n tuner-ADC-conditioner branches) and reconstructs the channel of interest contained in the receiver input signal 104 at the input of the splitter 201. In other words, embodiments of the present invention use n (analog) tuner-ADC branches and a digital combination of the fractions to overcome the bandwidth limitations of the individual tuner-ADC branches.

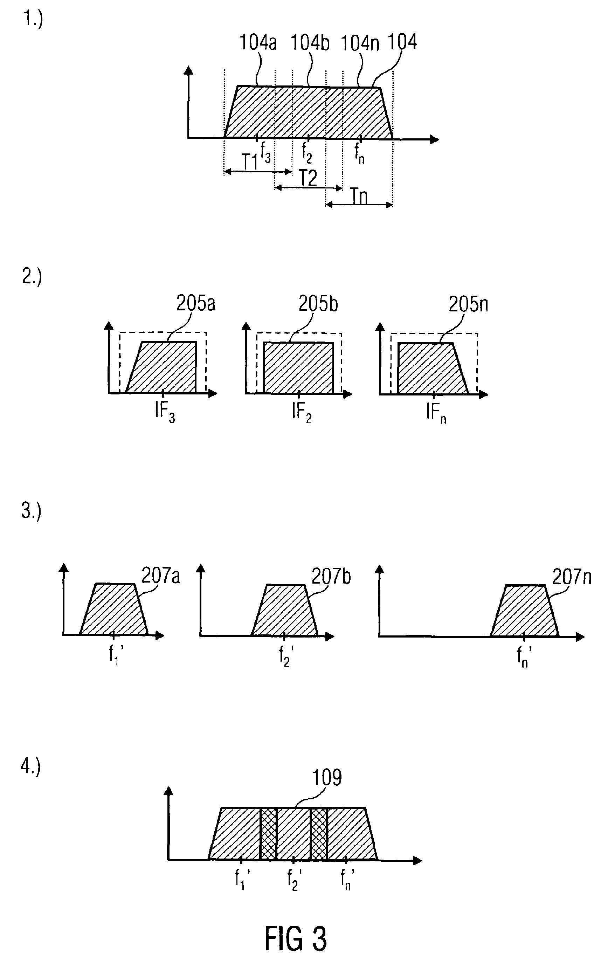

To achieve this, the channel of interest (e.g. in radio frequency) is divided into fractions (the plurality of splitter output signals 205a to 205n). This division is done in a manner that all portions of the channel of interest (of the receiver input signal 104) are covered, for example by splitting the channel of interest into n adjacent disjoint or overlapping fractions. Fig. 3 shows as an example in a first diagram a channel of interest (e.g. in RF, the receiver input signal 104) as a trapezoid shaped area.

The receiver input signal 104 comprises a first portion 104a, a second portion 104b and a third portion 104n. The first portion 104a overlaps the second portion 104b and the second portion 104b also overlaps with the third portion 104n. The first portion (104a) comprises a first center frequency $f_1$, the second portion 104b comprises a second center frequency $f_2$ and the third portion 104n comprises a third center frequency $f_n$.

The vertical lines show one possible spit of this channel (of the receiver input signal 104) into fractions (into the portions 104a to 104n) that are assigned to the tuner branches T1, T2, ... Tn (to the tuner branches 209a to 209n). As can be seen from the first diagram the different fractions are overlapping each other, but as mentioned before, may also be adjacent, for example adjacent disjoint. Each of these fractions is then fed into an independent tuner/ADC branch, for conditioning (amplification, filtering) and down converted to low or zero IF. The second diagram of Fig. 3 shows the fractions (the splitter output signals 205a to 205n), after a conditioning and down conversion to low or zero IF, for each of the tuner branches 205a to 205n (T1, T2,..., Tn). These analog signals are then converted into the digital domain using the analog-to-digital converter block 202, using the converting branches 211a to 211n (ADC1, ADC2,..., ADCn) respectively. In this figure, the dashed boxes around the fractions (around the splitter output signal 205a to 205n) indicate bandwidth limits of each of the tuner-ADC branches). As Fig. 3 indicates, the fractions of interest (the splitter output signals 205a to 205n) do not exceed the bandwidth constraints of each branch.

In a typical embodiment of the present invention, the receiver input signal 104 or the RF signal is amplified (in the splitting stage 208) and split into n identical signals (the splitting stage output signals 210a to 210n) and each signal is then fed into one tuner-ADC branch. Thus, each of the tuner branches (or tuners) 209a to 209n receives the full bandwidth receiver input signals 104 (or the full bandwidth RF signal) at its input. To implement the splitting into fractions (into the splitter output signals 205a to 205n), each tuner 209a to 209n may be configured to select and down convert the fraction assigned to it. This may be accomplished by configuring a mixer and filter circuitry of a certain tuner to cover and process the fraction assigned to that certain tuner. Thus, at the output of each of the n tuners 209a to 209n, a conditioned and down converted signal (the splitter output signals 205a to 205n) including the fraction of interest is available.

The said output signal of each tuner 209a to 209n includes the required fraction, but may also include other components of the spectrum above or below the corresponding fraction. The output signal (the splitter output signals 205a to 205n) of each tuner 209a to 209n may be a real or a complex (IQ) signal, at zero or low IF. The signal for each fraction (the splitter output signals 205a to 205n) will then be converted from analog to digital, using a converting branch 211a to 211n (ADC1 to ADCn) for each of the signal components (for each of the fractions). The converting branch and the converting branch sampling rate for a certain fraction may be chosen to match the overall bandwidth of this certain fraction (of the splitter output signals 205a to 205n), including the unwanted spectral components as far as these are required to mitigate aliasing.

At this stage, n real or complex signals (the digital signals 206a to 206n) are available in the digital domain. Each of these signals (or IQ signal pairs for complex signals) may include unwanted spectral components and may be centered at a different intermediate frequency (IF 1, IF2,..., IFn). As mentioned above, these n signals may also be centered at the same intermediate frequency. As a matter of component imperfections and different AGC (automatic gain control) settings, each of these signals may also differ in amplitude and/or phase over frequency (over frequency response). As a matter of signal runtime (trace length) and oscillator phase differences or local drifts in sampling time of the converting branches of 211a to 211n, each of these signals may also be subject to different time shifts and/or signal phases.

Thus, it is the responsibility of the subsequent digital processing (of the digital conditioner 104 and its conditioning stages 212a to 212n) to align the amplitudes and/or phases and/or arrival times of the individual signals (of the digital signals 206a to 206n). This alignment may also be called equalization. Furthermore, it is the responsibility of the subsequent digital processing to frequency shift the fractions to the correct position (relative to other fractions) and to remover (any) unwanted spectral components.

Fig. 3 shows in the third diagram the signal (the fractions from the second diagram) after further processing in digital. As part of the processing, each fraction (each digital signal 206a to 206n) is digitally filtered and modulated to an individual center frequency $f_1'$ to $fn'$. The fractions are therefore represented by the conditioned digital signals 207a to 207n before being fed into the combiner 203.

Fig. 2b shows two examples for a conditioning stage 212a-212n of the digital conditioner 204. Fig. 2b shows a conditioning stage 212 comprising a band-pass filter 213, a frequency shifter 214 and an aligner 215. The band-pass filter 215 is configured to perform the abovementioned band-pass filtering for removing unwanted spectral components of a digital signal 206. The frequency shifter 214 is configured to frequency shift the output signal of the band-pass filter 213 to a new individual center frequency (e.g. to the center frequency $f_1$'). The aligner 215 is configured to perform an amplitude and/or phase and/or time alignment of the output signal of the frequency shifter 214 such that amplitude and/or phase and/or timing of different conditioned digital signals 207a to 207n are aligned. The second shown conditioning stage 212' differs from the first shown conditioning stage 212 due to the fact that the digital signal 206 is frequency shifted by the frequency shifter 214 before being band-pass filtered by the band-pass filter 213. These two conditioning stages 212, 212' shall only show examples on how to arrange the different stages of the conditioning stages performing the band-pass filtering, frequency shifting and amplitude and/or phase and/or time aligning. According to further embodiments of the present invention, these stages may be arranged in other orders too.

In addition, if the fractions are overlapping, or in other words, if frequency ranges of the splitter output signals 205a to 205n correspond to overlapping portions of the receiver input signal 104, the digital processing (the conditioner 204 with its conditioning stages 212a to 212n) may ensure that the overlapping of the fractions result in a flat frequency response (as it will be explained later).

In order to perform amplitude and/or phase and/or time alignment (equalization) of the individual signals (of the digital signals 206a to 206n) representative properties of the individual signals may be measured (e.g. by the conditioning stages 212a to 212n). Such a property may be any property allowing an estimation of an amplitude and/or phase and/or timing offset of a fraction signal. Such properties include, but are not limited to, (known) pilot tones or any narrow band spectral portion in the spectral overlap (such as the overlap shown in the first diagram of Fig. 3) of the fractions (of the different portions corresponding to different frequency ranges of different splitter output signals). Using the amplitude and/or phase and/or time estimates for each fraction, an appropriate amplitude and/or phase and/or time correction can be applied (e.g. by the aligner 215) to each of the fractions, minimizing the amplitude and/or phase and/or timing offsets among the fractions.

In other words, the digital conditioner 204 may be configured to determine a first alignment property based on the first digital signal 206a and to determine a second alignment property based on the second digital signal 206b. The first alignment property and the second alignment property may determine an amplitude and/or phase and/or timing offset between the first digital signal 206a and the second digital signal 206b. The digital conditioner 204 may then be configured to perform an amplitude and/or phase and/or time alignment (e.g. using the aligner 215), such that the first conditioned digital signal 207a and the second conditioned digital signal 207b are amplitude and/or phase and/or time aligned. The digital conditioner 204, respectively its conditioning stages 212a to 212n, may naturally perform this determining of alignment properties and amplitude and/or phase and/or time aligning, for each of the plurality of digital signals 206a to 206n, such that the plurality of conditioned digital signals 207a to 207n are phased and/or amplitude and/or time aligned.

As mentioned before, as the tuner branches 209a to 209n converted each fraction to a zero or low-IF centered signal (the splitter output signal 205a to 205n) each centered around an intermediate frequency $IF_1$ to $IF_n$, the reconstruction of the full bandwidth signal (the receiver input signal 104) may require shifting the fractions back to the original (relative) center frequencies (e.g. the center frequencies $f_1$ to $f_n$, shown in the first diagram of Fig. 3). Assuming the fractions processed by the tuners T1 to Tn (by the tuner branches 209a to 209n) originally centered around the frequencies $f_1$ to $f_n$, respectively, the fractions are now centered at the same or individual intermediate frequencies $IF_1$ to $IF_n$, as previously explained. Thus, each fraction (the digital signals 206a to 206n) may be shifted by, for example, using a digital mixer (e.g. the frequency shifter 214 shown in Fig. 2b), to the new center frequencies $f_1$' to $f_n$', so that for each pair i; j of fractions, the equation

$$f_i - f_j = f_i' - f_j' \qquad (1)$$

is preserved.

In other words, the digital conditioner 204 may be configured to provide the first conditioned digital signal 207a such that the center frequency $f_1$' of the first conditioned digital signal 207a differs from the center frequency of the first digital signal $IF_1$. The digital conditioner is further configured to provide the second conditioned digital signal 207b such that the center frequency $f_2$' of the second conditioned digital signal 207b differs from the center frequency $IF_2$ of the second digital signal 206b. The digital conditioner is further configured such that a difference between the center frequency $f_1$ of the first portion of the first frequency range of the receiver input signal 104, the first portion corresponding to the second frequency range of the first splitter signal 105 a and the center frequency $f_2$ of the second portion of the first frequency range of the receiver input signal 104, the second portion corresponding to the third frequency range of the second splitter signal 105b is equal to a difference between the center frequency $f_1$' of the first conditioned digital signal 207a and the center frequency $f_2$' of the second conditioned digital signal 207b. Naturally, the digital conditioner 204 (and its conditioning stages 212a to 212n) may be configured to perform this frequency shift (e.g. using frequency shifters 214) with a plurality of digital signals 206a to 206n such that for all digital condition signals 207a to 207n the abovementioned equation is preserved. As mentioned before, each of the digital signals 206a to 206n may comprise unwanted (spectral) components. To remove these unwanted signal components, band-pass filtering (e.g. using band-pass filters 213 in the conditioning stages 212a to 212n) may be applied to each of the fractions (to each of the digital signals 206a to 206n). Too allow for later additive combining the fractions (of the conditioned digital signal 207a to 207n), the filter transfer function of the band-pass filters 213 may be chosen in a manner that the added filtered transfer functions are constant (in phase and amplitude).

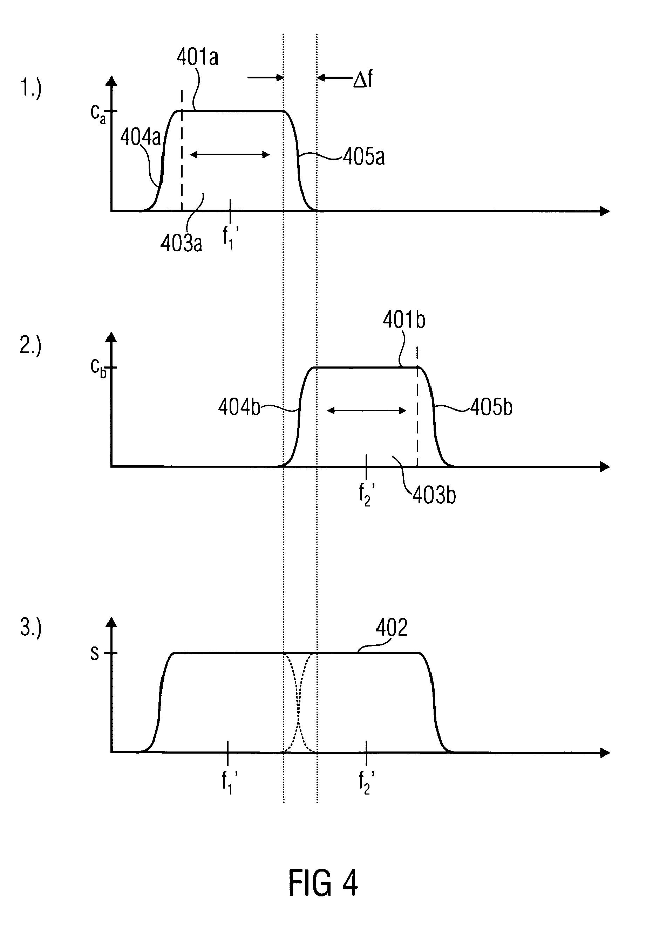

Fig. 4 shows in a first diagram, a first filter transfer function 401a centered at the center frequency $f_1$', which may be the same as the center frequency $f_1$' of the conditioned digital signal 207a shown in Fig. 3. The first filter transfer function 401a may for example be the filter transfer function of a first band-pass filter 213a of the first conditioning stage 212a.

Furthermore shows Fig. 4 in a second diagram a second filter transfer function 401b with a second center frequency $f_2$', which may for example be the center frequency $f_2$' of the second conditioned digital signal 207b shown in Fig. 3. The second filter transfer function 401b may for instance be a filter transfer function of the second band-pass filter 213b of the second conditioning stage 212b of the digital conditioner 204.

Furthermore shows Fig. 4 in a third diagram a third filter transfer function 402, which may for example be a filter transfer function of the digital conditioner 204 (e.g. if it comprises only the first conditioning stage 212a and the second conditioning stage 212b. The third filter transfer function 402 is an additive combination of the first filter transfer function 401a and the second filter transfer function 401b. If the two fractions (e.g. the first and the second portion) overlap in a range $\Delta f$, the individual transfer functions (the first transfer function 401a and the second transfer function 401b) of the corresponding filters (of the first band-pass filter 213a and the second band-pass filter 213b) should add up to obtain an overall constant transfer function (the third transfer function 402).

As mentioned before, a band-pass filter 413 may be applied before or after a fraction is frequency shifted to a center frequency around $f_1$' to $f_n$' (as has been shown with the two different conditioning stages 412 to 412' in Fig. 2b. Fig. 4 assumes, for illustrative purposes only, filtering, after a frequency shift has occurred (such as is shown in the digital conditioning stage 212 of Fig. 2b).

In other words, the digital conditioner 204 (and its conditioning stages 212a to 212n) may be configured to perform a digital band-pass filtering, such that the first conditioned digital signal 207a comprises the second bandwidth (of the first portion and of the first splitter output signal 205a) and such that the second conditioned signal 207b comprises the second bandwidth (of the second portion and of the second splitter output signal 205b). A pass-band of a filter applied in the digital conditioner 204 may therefore be dependent on the bandwidth of the fraction (of the digital signal out of the plurality of digital signals 206a-206n) to which the band-pass filtering is applied.

Furthermore, especially if neighboring fractions or portions overlap (as it has been shown in Fig. 3), transfer functions of this applied filter may overlap. In other words, the digital conditioner 204 may be configured such that the first filter transfer function 401a for providing the first conditioned digital signal 207a and the second filter transfer function 401b for providing the second conditioned digital signal 207b are chosen such that a first value $c_a$ of a first constant area 403a of the first filter transfer function 401a between a rising slope 404a and a falling slope 405a of the first filter transfer function 401a is equal to a second value $c_b$ of a second constant area 403b of the second filter transfer function 401b between a rising slope 404b and a falling slope 405b of the second filter transfer function 401b. Furthermore, the digital conditioner 204 may be configured such that the result s of the sum of the falling slope 405a of the first filter transfer function 401a and of the rising slope 404b of the second filter transfer function 401b is equal to the first value $c_a$ and the second value $c_b$. The resulting filter transfer function 402 is therefore constant, in the overlap area $\Delta f$ of the first filter transfer function 401a and the second filter transfer function 401b and in the constant areas 403a, 403b of the filter transfer functions 401a, 401b.

In short, Fig. 4 assumes two fractions (the first conditioned digital signal 207a and the second conditioned digital signal 207b), centered at $f_1$' and $f_2$', respectively and overlapping by $\Delta f$ in the frequency domain. The topmost and the middle diagram (the first and the second diagrams) give the frequency response (or the filter transfer function) for the (digital) filters applied to the first and second fraction. The third diagram shows the filter response (the filter transfer function 402) when adding the two filter responses. As shown, the two filters (e.g. the first band-pass filter 213a and the second band-pass filter 213b) are constructed to have the same constant filter response when added in the overlap area $\Delta f$. The same constant filter response applies to each one of the two filters for the remaining parts (the constant parts 403a and 403b) of the fraction, outside the overlap area $\Delta f$.

Although Fig. 4 only showed two filter transfer functions, for example of the first band-pass filter 213a of the first conditioning stage 212a and of the second band-pass filter 213 of the second conditioning stage 212b, this example may also be extended to a free-chosen number of filter transfer functions of band-pass filters of conditioning stages of the digital conditioner 204 (e.g.

depending on the number of tuner-ADC branches and splitter output signals 205a to 206n).

If the frequency shift of the fractions occur after band-pass filtering, and if every fraction has the same bandwidth centered at the same intermediate frequency IF, the same band-pass filter with the same filter transfer function may be applied to all fractions (to all digital signals 206a to 206n). After band-pass filtering, the band-pass filtered signals have of course to be frequency shifted (and aligned).

The conditioned digital signals 207a to 207n are then combined using the combiner 203 to get the combined digital signal 109 comprising the first bandwidth of the receiver input signal 104. In other words, the fraction signals, centered at $f_1'$ to $f_n'$ and individually band-pass filtered are combined, to reconstruct a digital representation (the combined digital signal 109) of the full bandwidth signal (of the receiver input signal 104, which may for example be an RF signal). This is shown in a fourth diagram of Fig. 3. The fourth diagram shows the resulting final signal 109, after additive combination of these fractions (conditioned digital signals 207a to 207n), as shown in Fig. 4, the fractions may overlap in frequency (as described before); this corresponds to the overlap of the tuner branches T1 to Tn shown in the first diagram of Fig. 3.

Although, in Fig.4 the two filters are constructed to have the same constant filter response when added in the overlap area $\Delta f$, according to further embodiments it may be sufficient to use known filter transfer functions (which may not have a constant filter response when added in the overlap area $\Delta f$) in each of the band-pass filters 213a to 213n, as long as the inverse filter transfer function for the sums of the filter transfer functions of the band-pass filters 213a to 213n can be constructed (or approximated). This inverse transfer function may be applied after combining of the conditioned digital signals 207a to 207n by the combiner 203. The combined digital signal 109 provided by the combiner 203 may then be filtered using this inverse transfer function. This filtering may for example be applied by using an optional block channel equalizer 216, which is shown in Fig. 2a. The block channel equalizer 216 is therefore configured to filter the combined digital signal 109 using the above mentioned inverse filter transfer function, which may depend on properties of the tuner-ADC-conditioner branches to provide a filtered combined digital signal 217, being a digital representation of the analog receiver input signal 104.

Although in the embodiment shown in Fig. 2a, the splitter 201 is directly connected to the analog-to-digital converter block 202 and the analog-to-digital converter block 202 is directly connected to the digital conditioner 204 and the digital conditioner 204 is directly connected to the combiner 203 and the combiner is directly connected to the block channel equalizer 216, according to further embodiments, additional blocks, for example, for filtering, amplification, signal conditioning, equalization etc. in the analog and/or digital domain may be applied between the splitter 201, the analog-to-digital converter block 202, the digital conditioner 204, the combiner 203 and the block channel equalizer 216.

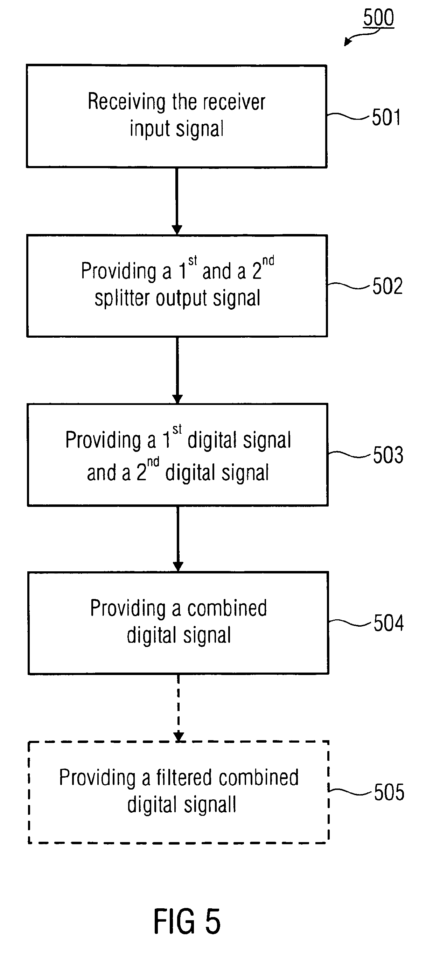

Fig. 5 shows a flow diagram of a method 500 for processing a receiver input signal, the receiver input signal comprising a first bandwidth and a first frequency range.

The method 500 comprises a step 501 of receiving the receiver input signal.

The method 500 further comprises a step 502 of providing, based on the receiver input signal, a first splitter output signal, such that the first splitter output signal comprises a second bandwidth in a second frequency range, the second bandwidth being smaller than the first bandwidth and providing, based on the receiver input signal, a second splitter output signal, such that the second splitter output signal comprises a third bandwidth in a third frequency range, the third bandwidth being smaller than the first bandwidth.

The method 500 further comprises a step 503 of providing a first digital signal based on the first splitter output signal and providing a second digital signal based on the second splitter output signal.

The method 500 further comprises a step 504 of providing a combined digital signal based on the first digital signal and the second digital signal, the combined digital signal comprising the first bandwidth.

The method 500 may optionally further comprise a step 505 of providing a filtered combined digital signal, being a digital representation of the receiver input signal. The step 505 may for example be a block channel equalization step.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, some one or more of the most important method steps may be executed by such an apparatus.

Depending on certain implementation requirements, embodiments of the invention can be implemented in hardware or in software. The implementation can be performed using a digital storage medium, for example a floppy disk, a DVD, a Blue-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

**Claims**

1. A receiver comprising:

a splitter (101, 201) configured to receive a receiver input signal (104), the receiver input signal (104) comprising a first bandwidth ($B_1$) and a first frequency range ($f_{11}$ to $f_{12}$);
wherein the splitter (101, 201) is further configured to provide, based on the receiver input signal (104) a first splitter output signal (105, 205a), such that the first splitter output signal (105, 205a) comprises a second bandwidth ($B_2$) and a second frequency range ($f_{14}$ to $f_{15}$), the second bandwidth ($B_2$) being smaller than the first bandwidth ($B_1$) and to provide, based on the receiver input signal (104),
a second splitter output signal (106, 205b), such that the second splitter output signal (106, 205b) comprises a third bandwidth ($B_3$) and a third frequency range ($f_{16}$ to $f_{17}$), the third bandwidth ($B_3$) being smaller than the first bandwidth ($B_1$);
an analog-to-digital converter block (102, 202) configured to provide a first digital signal (107, 206a) based on the first splitter output signal (105, 205a) and
to provide a second digital signal (108, 206b) based on the second splitter output signal (106, 205b); and
a combiner (103, 203) configured to provide a combined digital signal (109) based on the first digital signal (107, 206a) and the second digital signal (108, 206b), the combined digital signal (109) comprising the first bandwidth ($B_1$).

2. The receiver according to claim 1, wherein the second frequency range ($f_{14}$ to $f_{15}$) corresponds to a first portion (104a) of the first frequency range ($f_{11}$ to $f_{12}$) and the third frequency range ($f_{16}$ to $f_{17}$) corresponds to a second portion (104b) of the first frequency range ($f_{11}$ to $f_{12}$).

3. The receiver according to claim 2, wherein the first portion (104a) of the first frequency range ($f_{11}$ to $f_{12}$) overlaps with the second portion (104b) of the first frequency range ($f_{11}$ to $f_{12}$) in a common overlap range ($f_{13-x}$ to $f_{13+x}$), the common overlap range ($f_{13-x}$ to $f_{13+x}$) being smaller than the second bandwidth ($B_2$) and the third bandwidth ($B_3$).

4. The receiver according to claim 2, wherein the first portion (104a) of the first frequency range ($f_{11}$ to $f_{12}$) and the second portion (104b) of the first frequency range ($f_{11}$ to $f_{12}$) are adjacent to each other.

5. The receiver according to one of the claims 2 to 4, wherein the splitter (201) comprises a first tuner branch (209a) configured to provide, based on the receiver input signal (104) the first splitter output signal (205a) and a second tuner branch (209b) configured to provide, based on the receiver input signal (104) the second splitter output signal (205b);

wherein a passband of the first tuner branch (209a) corresponds to the first portion (104a) of the first frequency range ($f_{11}$ to $f_{12}$); and

wherein a passband of the second tuner branch (209b) corresponds to the second portion (104b) of the first frequency range ($f_{11}$ to $f_{12}$).

6. The receiver according to claim 5, wherein the first tuner branch (209a) is configured to provide the first splitter output signal (205a) such that a center frequency ($IF_1$) of the second frequency range is lower than a center frequency ($f_1$) of the first portion (104a) of the first frequency range and wherein the second tuner branch (209b) is configured to provide the second splitter output signal (205b) such that a center frequency ($IF_2$) of the third frequency range is lower than a center frequency ($f_2$) of the second portion (104b) of the first frequency range.

7. The receiver according to claim 6, wherein the center frequency ($IF_1$) of the second frequency range is equal to the center frequency ($IF_2$) of the third frequency range.

8. The receiver according to one of the claims 1 to 7, further comprising a digital conditioner (204) in between the analog-to-digital converter block (202) and the combiner (203), the digital conditioner (204) being configured to provide a first conditioned digital signal (207a) based on the first digital signal (206a) and to provide a second conditioned digital signal (207b) based on the second digital signal (206b), wherein the combiner (203) is further configured to provide the combined digital signal (109) based on the first conditioned digital signal (207a) and the second conditioned digital signal (207b).

9. The receiver according to claim 8, wherein the digital conditioner (204) is further configured to determine a first alignment property based on the first digital signal (206a) and to determine a second alignment property based on the second digital signal (206b); wherein the first alignment property and the second alignment property determine an amplitude and/or phase and/or timing offset between the first digital signal (206a) and the second digital signal (206b); and

wherein the digital conditioner (204) is configured to perform an amplitude and/or phase and/or time alignment such that the first conditioned digital signal (207a) and the second conditioned digital signal (207b) are amplitude and/or phase and/or time aligned.

10. The receiver according to one of the claims 8 or 9, wherein the digital conditioner (204) is configured to provide the first conditioned digital signal (207a) such that a center frequency ($f_1'$) of the first conditioned digital signal (207a) differs from a center frequency ($IF_1$) of the first digital signal (206a) and to provide the second conditioned digital signal (207b) such that a center frequency ($f_2'$) of the second conditioned digital signal (207b) differs from a center frequency ($IF_2$) of the second digital signal (206b); and

wherein the digital conditioner (204) is further configured to provide the first conditioned digital signal (207a) and the second conditioned digital signal (207b) such that a difference between a center frequency ($f_1$) of a first portion (104a) of the first frequency range, the first portion (104a) corresponding to the second frequency range, and a center frequency ($f_2$) of a second portion (104b) of the first frequency range, the second portion (104b) corresponding to the third frequency range, is equal to a difference between the center frequency ($f_1'$) of the first conditioned digital signal (207a) and the center frequency ($f_2'$) of the second conditioned digital signal (207b).

11. The receiver according to one of the claims 7 to 10, wherein the digital conditioner (203) is configured to perform a digital band-pass filtering such that the first conditioned signal (207a) comprises the second bandwidth and such that the second conditioned signal (207b) comprises the third bandwidth.

12. The receiver according to claim 11, wherein a first filter transfer function (401a) for providing the first conditioned digital signal (207a) and a second filter transfer function (401 b) for providing the second conditioned digital signal (207b) are chosen such that a first value ($c_a$) of a first constant area (403a) of the first filter transfer function (401a) between a rising slope (404a) and a falling slope (405a) of the first filter transfer function (401a) is equal to a second value ($c_b$) of a second constant area (403b) of the second filter transfer function (401b) between a rising slope (404b) and a falling slope (405b) of the second filter transfer function (401b) and such that a sum ($s$) of the falling slope (405a) of the first filter transfer function (401a) and of the rising slope (404b) of the second filter transfer function (401b) is equal to the first value ($c_a$) and the second value ($c_b$).

13. The receiver according to one of the claims 1 to 12, wherein the splitter (201) is configured to provide, based on the receiver input signal (104), a plurality of splitter output signals (205a - 205n), each comprising a bandwidth and a frequency range, such that frequency ranges of each splitter output signal (205a - 205n) correspond each to a portion (104a - 104n) of the first frequency range of the receiver input signal (104) and such that every portion (104a - 104n) of the first frequency range corresponds to at least one frequency range of a splitter output signal of the plurality of splitter output signals (205a - 205n);

wherein the analog-to-digital converter block (202) is configured to provide a plurality of digital signals (206a - 206n) based on the plurality of splitter output signals (205a - 205n); and

wherein the combiner (203) is configured to provide the combined digital signal (109), based on the plurality of digital signals (206a - 206n).

14. The receiver according to one of the claims 1 to 13, further comprising a block channel equalizer (216) configured to provide, based on the combined digital signal (109) a filtered combined digital signal (217), the filtered combined digital signal (217) being a digital representation of the receiver input signal (104).

15. A method for processing a receiver input signal (104), the receiver input signal (104) comprising a first bandwidth ($B_1$) and a first frequency range ($f_{11}$ to $f_{12}$) comprising:

providing (502), based on the receiver input signal (104), a first splitter output signal (105, 205a) such that the first splitter output signal (105, 205a) comprises a second bandwidth ($B_2$) and a second frequency range ($f_{14}$ to $f_{15}$), the second bandwidth ($B_2$) being smaller than the first bandwidth ($B_1$) and providing, based on the receiver input signal (104), a second splitter output signal (106, 205b) such that the second splitter output signal (106, 205b) comprises a third bandwidth ($B_3$) and a third frequency range ($f_{16}$ to $f_{17}$), the third bandwidth ($B_3$) being smaller than the first bandwidth ($B_1$);

providing (503) a first digital signal (107, 206a) based on the first splitter output signal (105, 205a) and providing a second digital signal (108, 206b) based on the second splitter output signal (106, 205b); and

providing (504) a combined digital signal (109) based on the first digital signal (107, 206a) and the second digital signal (108, 206b), the combined digital signal (109) comprising the first bandwidth ($B_1$).

16. A computer program comprising a program code for performing the method according to claim 15 when the computer program runs on a computer.

FIG 1A

1.)

$B_1$

104

$f_{11}$   $f_{13-x}$ $f_{13}$ $f_{13+x}$   $f_{12}$

104a   104b

splitter
101

2.)

$B_2$

105

$f_{14}$   $f_{c1}$   $f_{15}$

$B_3$

106

$f_{16}$   $f_{c2}$   $f_{17}$

analog
digital

ADC
102

3.)

107

$f_{14}$   $f_{c1}$   $f_{15}$

108

$f_{16}$   $f_{c2}$   $f_{17}$

combiner
103

4.)

$B_1$

109

$f_{18}$   $f_{19}$

# FIG 1B

FIG 2A

EP 2 403 145 A1

FIG 2B

FIG 3

FIG 4

500

```
┌─────────────────────────┐
│    Receiving the receiver    │───501
│       input signal          │
└─────────────────────────┘
             │
             ▼
┌─────────────────────────┐
│  Providing a 1$^{st}$ and a 2$^{nd}$  │───502
│    splitter output signal    │
└─────────────────────────┘
             │
             ▼
┌─────────────────────────┐
│  Providing a 1$^{st}$ digital signal  │───503
│   and a 2$^{nd}$ digital signal    │
└─────────────────────────┘
             │
             ▼
┌─────────────────────────┐
│    Providing a combined    │───504
│       digital signal        │
└─────────────────────────┘
             ┆
             ▼
┌─ ─ ─ ─ ─ ─ ─ ─ ─ ─ ─ ─ ─┐
│  Providing a filtered combined  │───505
│       digital signall        │
└─ ─ ─ ─ ─ ─ ─ ─ ─ ─ ─ ─ ─┘
```

FIG 5

| | sampling rate | nominal resolution | power consumption |
|---|---|---|---|
| 1. Group | 100 MSps | 8 Bit<br>10 Bit<br>16 Bit | 0.07 W |
| 2. Group | 210 MSps | 10 Bit<br>12 Bit | 0.45 W |
| 3. Group | 400 MSps | 6 Bit | 1.3 W |

# FIG 6

Europäisches
Patentamt

European
Patent Office

Office européen
des brevets

# EUROPEAN SEARCH REPORT

Application Number

EP 10 16 8109

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2009/036981 A1 (INNOVATIONSZENTRUM FUER TELEKO [DE]; PERTHOLD RAINER [DE]) 26 March 2009 (2009-03-26) * abstract * * figures 1-4,7-9 * * page 1, line 8 - page 3, line 5 * * page 3, lines 7-21 * * page 3, lines 23-25 * * page 3, line 27 - page 4, line 5 * * page 8, line 30 - page 12, line 25 * * page 15, line 17 - page 17, line 22 * * page 17, line 24 - page 18, line 12 * * page 18, line 14 - page 19, line 6 * ----- | 1-16 | INV. H03M1/12 H04B1/28 H04B1/40 ADD. H04B1/00 |
| X | WO 2007/055647 A2 (ERICSSON TELEFON AB L M [SE]) 18 May 2007 (2007-05-18) * abstract * * figures 5-12 * * paragraph [0007] - paragraph [0009] * * paragraph [0030] - paragraph [0033] * * paragraph [0034] - paragraph [0040] * ----- | 1-16 | |
| | | | TECHNICAL FIELDS SEARCHED (IPC) H03M H04B |

The present search report has been drawn up for all claims

| Place of search | Date of completion of the search | Examiner |
|---|---|---|
| The Hague | 13 December 2010 | Niederholz, Jürgen |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**ANNEX TO THE EUROPEAN SEARCH REPORT
ON EUROPEAN PATENT APPLICATION NO.**                    EP 10 16 8109

This annex lists the patent family members relating to the patent documents cited in the above-mentioned European search report.
The members are as contained in the European Patent Office EDP file on
The European Patent Office is in no way liable for these particulars which are merely given for the purpose of information.

13-12-2010

| Patent document cited in search report | Publication date | Patent family member(s) | Publication date |
|---|---|---|---|
| WO 2009036981 A1 | 26-03-2009 | DE 102007044469 A1<br>EP 2191579 A1 | 09-04-2009<br>02-06-2010 |
| WO 2007055647 A2 | 18-05-2007 | CA 2627417 A1<br>EP 1949637 A2<br>JP 2009516420 T<br>US 2007110198 A1 | 18-05-2007<br>30-07-2008<br>16-04-2009<br>17-05-2007 |

EPO FORM P0459

For more details about this annex : see Official Journal of the European Patent Office, No. 12/82

**EP 2 403 145 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6031878 A
- US 7095454 B
- US 20090258629 A1
- US 7167694 B
- US 7304689 B
- US 20060128328 A
- US 6519011 B
- US 6363262 B
- US 5590156 A